# EUROPEAN PATENT APPLICATION

(11) **EP 2 731 129 A1**
(43) Date of publication of application: **14.05.2014**
(21) Application number: 12191647.2
(22) Date of filing: 07.11.2012
(51) Int. Cl.: H01L 23/31, B81C 1/00, G01N 27/12, H01L 21/50

(54) **Molded semiconductor sensor device and method of producing the same at a wafer-level**

(71) Applicant: ams AG, 8141 Unterpremstätten (AT)
(72) Inventor: Schrank, Franz, 8052 Graz (AT); Schrems, Martin, 8063 Eggersdorf (AT)
(74) Representative: Epping - Hermann - Fischer

(57) **Abstract**

The semiconductor device comprises a substrate (1) of semiconductor material with a front side (4) and an opposite rear side (7), a wiring layer (5) at the front side (4), a further wiring layer (8) at the rear side (7), and a through-substrate via (3) connecting the wiring layer (5) and the further wiring layer (8). A mold compound (14) is arranged on the rear side (7) above the substrate (1), a cavity (17) is formed in the mold compound (14), a sensor layer (21) is arranged in the cavity (17), and the cavity (17) is covered with a membrane (15). The mold compound (14) is applied on the wafer, and a film assisted molding process can be used.

## Description

US 7 495 300 B2 discloses a gas-sensing semiconductor device on silicon, comprising a resistive heater made of tungsten embedded in a thin silicon oxide layer that is formed over a recess of the silicon substrate. The device can be monolithically integrated with a circuitry using a CMOS process.

US 7 659 612 B2 discloses semiconductor components comprising through wire interconnects, which are partially encapsulated by a polymer layer and include redistribution conductors and pads electrically connected with substrate contacts. A method for fabricating the components can include a film assisted molding process for forming the polymer layer on the wafer level. Following the film assisted molding process the components are singulated. The semiconductor components can be used to fabricate stacked systems.

TW 1290358 B discloses a packaging for a micro gas sensor, which is mounted in a receptacle of a carrier and is provided with electric connections. The receptacle is closed by a filter component, which is fixed to the carrier above the sensor and comprises a structure net and a thin film.

KR 101034647 B1 describes a wafer-level packaging for a gas sensor. A substrate comprising cavities containing sensors and support units is covered with a further substrate, which is provided with a cavity and an infrared filter. The substrates are bonded by means of a metal solder layer.

US 2012/0056312 A1 describes a production method for a stack of semiconductor wafers comprising through silicon vias and a plurality of dies mounted in cavities between the vias. An encapsulant is deposited over the dies. Interconnect structures are formed above the encapsulant and are electrically connected to the vias. When the wafers are provided with the encapsulant and the interconnect structures, they are mounted on top of each other.

It is an object of the invention to disclose a new wafer-level package that is particularly suitable for gas sensors, and an appertaining method of production.

This object is achieved with the semiconductor device in wafer-level package according to claim 1 and with the method of producing a semiconductor device in wafer-level package according to claim 9. Embodiments and variants derive from the dependent claims.

The semiconductor device that is produced in wafer-level package comprises a substrate of semiconductor material with a front side and an opposite rear side, a wiring layer at the front side, a further wiring layer at the rear side, and a through-substrate via connecting the wiring layer and the further wiring layer. A sensor layer is arranged at the rear side above or in the substrate and is electrically connected with the further wiring layer. A mold compound is arranged on the rear side and is covered with a membrane. The mold compound and the membrane form a cavity accomodating the sensor layer

An embodiment of the semiconductor device comprises a sensor chip within the cavity, and the sensor layer is arranged on or in the sensor chip. The sensor chip may be partially embedded into the mold compound.

In a further embodiment the sensor layer is arranged on or in the substrate.

In a further embodiment an integrated hot plate is arranged on or in the substrate in the vicinity of the sensor layer.

In a further embodiment the hot plate is part of the further wiring layer.

In a further embodiment the membrane is polytetrafluoroethylene or expanded polytetrafluoroethylene.

In a further embodiment a further sensor layer is arranged at the rear side above or in the substrate and is electrically connected with the further wiring layer. The sensor layer is provided for a chemical sensor, and the further sensor layer is provided for a humidity sensor. The membrane covers the cavity accomodating the sensor layer and comprises an aperture above the further sensor layer.

The method of producing a semiconductor device in wafer-level package comprises the steps of forming a plurality of semiconductor devices on a substrate of semiconductor material with a front side and an opposite rear side, arranging a wiring layer at the front side, arranging a further wiring layer at the rear side, forming through-substrate vias connecting the wiring layer and the further wiring layer, arranging a plurality of sensor layers in or above the substrate at the rear side, arranging and structuring a mold compound on the rear side above the substrate to form a plurality of cavities for the accomodation of the sensor layers, and covering the cavities with a membrane.

In a variant of the method the membrane is formed from polytetrafluoroethylene or expanded polytetrafluoroethylene.

In a further variant of the method the membrane is temporarily covered with a protection film. This may be favourable to enable a solder reflow process without poisoning the sensor layers.

In a further variant of the method the membrane is glued to the mold compound.

In a further variant of the method the membrane is ultrasonically welded to the mold compound.

In a further variant of the method the mold compound is applied in a structured fashion by use of a film assisted molding process.

In a further variant of the method the sensor layers are applied by mounting a plurality of sensor chips on the rear side of the substrate.

In a further variant of the method the sensor chips are partially embedded into the mold compound.

The following is a detailed description of examples of the semiconductor device and the method of production in conjunction with the accompanying drawings.
Figure 1 shows a cross section of an arrangement of sensor chips on a semiconductor substrate.
Figure 2 shows a cross section according to Figure 1 after the application of a mold compound.
Figure 3 shows a cross section according to Figure 2 after the application of a covering membrane.
Figure 4 shows a cross section according to Figure 2 for a further embodiment.
Figure 5 shows a cross section according to Figure 4 after the application of a covering membrane.
Figure 6 shows a cross section according to Figure 5 after the formation of an aperture.
Figure 7 shows a cross section of a further arrangement of sensor chips on a semiconductor substrate.
Figure 8 shows a cross section according to Figure 7 after the application of a mold compound.
Figure 9 shows a cross section according to Figure 8 after the application of a covering membrane.
Figure 10 shows a cross section of an embodiment with integrated sensor after the application of a covering membrane.

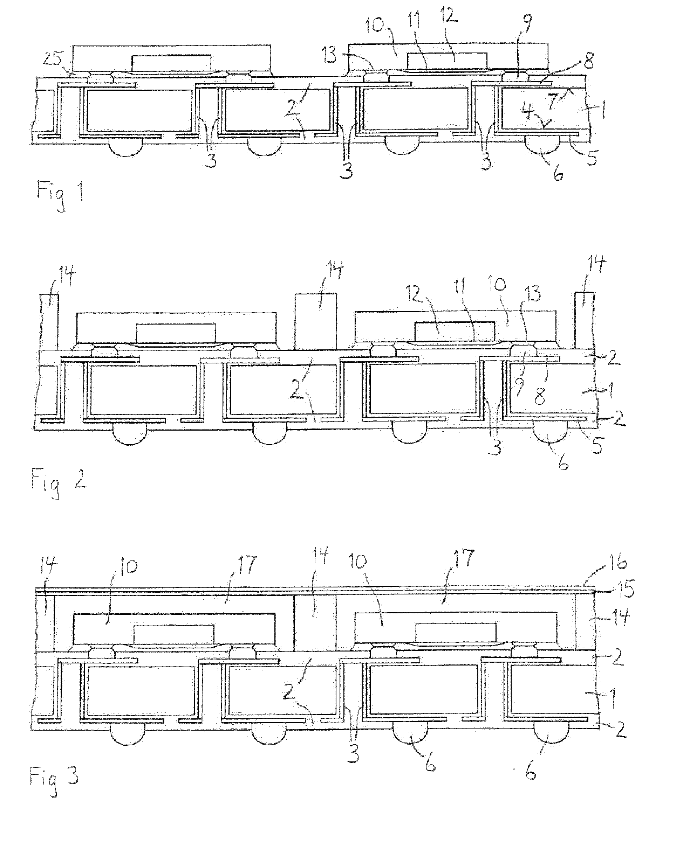

Figure 1 shows a cross section of an arrangement of sensor chips 10 on a substrate 1 of semiconductor material, which may be silicon, for example. The substrate 1 is provided with a dielectric 2, through-substrate vias 3, a wiring layer 5 embedded in the dielectric 2 at a front side 4 and provided with stud bumps 6, and a further wiring layer 8 embedded in the dielectric 2 at a rear side 7 opposite to the front side 4 and provided with contact pads 9. The dielectric 2 may comprise an oxide of the semiconductor material, for instance, particularly silicon dioxide, and/or a nitride of the semiconductor material, particularly Si₃N₄. The dielectric 2 may be a passivation formed from any suitable passivating dielectric material.

The through-substrate vias 3 are formed by metallizations, which are applied to sidewalls of via holes in the substrate 1. The cores of the through-substrate vias 3 can be free from the metallizations and left void, or they may be filled with a further material, which may be electrically conductive or insulating. The appended figures show the through-substrate vias 3 filled with the dielectric 2, but in other embodiments the inner volume of the through-substrate vias 3 may be void, and their sidewall metallizations may be covered by a thin protecting and/or insulating layer, for example.

The conductor layers, which are designated as wiring layer 5 and further wiring layer 8, may be any structured metal layer or a plurality of metal layers arranged on different metallization levels. If there are two or more metallization levels, the dielectric 2 may be provided as an intermetal dielectric. The conductor layers may include the wiring of an integrated circuit, which may especially comprise CMOS devices arranged at the front side 4 or at the rear side 7, and/or a redistribution layer, for example.

The stud bumps 6 are shown by way of example and can be substituted with any contact connections suitable for external electrical terminals. The same applies to the contact pads 9, which can also be stud bumps or solder balls or the like. If solder balls are used, they are preferably provided with an underbump metallization, which is applied as an additional thin layer according to standard semiconductor technology and is hence not shown in the figures. The conductors on the opposite sides of the substrate 1 are interconnected by means of the through-substrate vias 3.

A plurality of sensor chips 10 is mounted on the rear side 7 of the substrate 1. The sensor chips 10 comprise sensor layers 11, which may be single or multiple layers of any suitable structure and composition. It may be favourable to have the sensor layer 11 above a recess 12 of the sensor chip 10, especially in the case of a sensor layer 11 that is to be heated during operation, because a recess 12 provides a thermal isolation. The electrical connection of the sensor chips 10 is provided by means of contact pads 13, which contact the corresponding contact pads 9 of the substrate 1. An underfill 25 may optionally be provided to close the gaps between the sensor chips 10 and the dielectric 2 on the rear side 7.

Figure 2 shows a cross section according to Figure 1 after the application of a mold compound 14 above the rear side 7 of the substrate 1. The mold compound 14 is structured into compartments, which are enclosed by posts or walls formed by the mold compound 14. The sensor chips 10 are thus arranged in the compartments of the mold compound 14. The application and structuring of the mold compound 14 may be facilitated by a film assisted molding process, which is known per se.

Figure 3 shows a cross section according to Figure 2 after the application of a covering membrane 15, which closes the compartments of the sensor chips 10, so that cavities 17 are formed. Materials that are particularly suitable for the membrane 15 are polytetrafluoroethylene (PTFE) or expanded polytetrafluoroethylene (ePTFE). It may be favourable to cover the membrane temporarily with a protection film 16, especially if further process steps are performed that are liable to poison the sensor layers or otherwise adversely affect the components, like a solder reflow process, for example. The protection film 16 is afterwards removed, whereas the membrane 15 is provided as a permanent cover or protection, especially for sealing the cavity up to prevent water from entering. The substrate 1 is divided into individual semiconductor devices by a wafer dicing process. The stud bumps 6 can then be used as terminals for an external electric connection of the sensors.

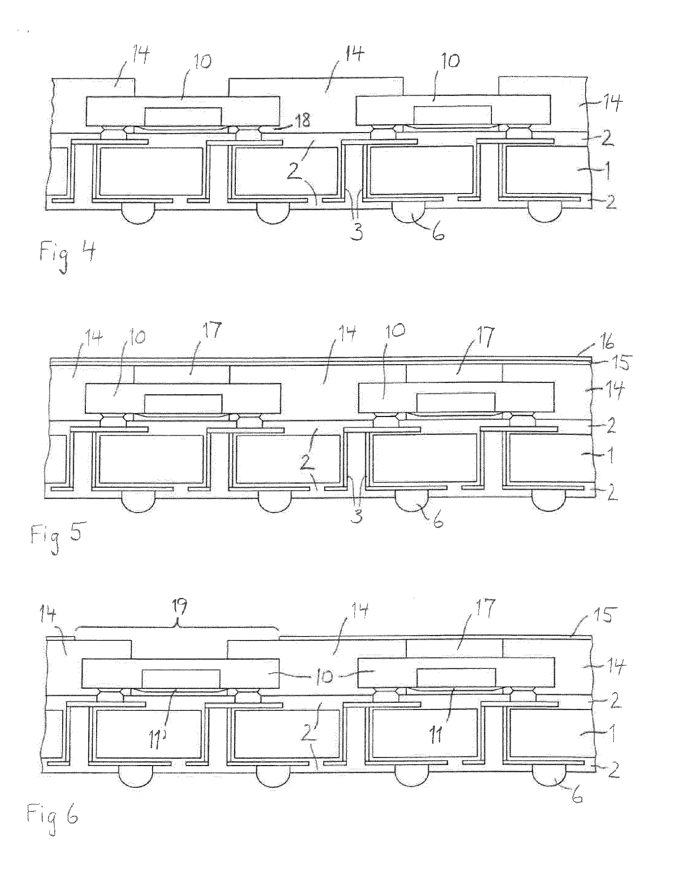

Figure 4 shows a cross section according to Figure 2 for a further embodiment, in which the sensor chips 10 are partially embedded into the mold compound 14. This variant of the method may be a favourable alternative to the application of an underfill to close the gaps 18 between the sensor chips 10 and the dielectric 2 of the substrate 1. The elements of the embodiment according to Figure 4 that are similar to the corresponding elements of the embodiment according to Figure 2 are designated with the same reference numerals and need not be described again.

Figure 5 shows a cross section according to Figure 4 after the application of the membrane 15 and an optional protection film 16 as described above. Figure 5 shows that the differently structured mold compound 14 yields smaller cavities 17 in comparison with the cavities 17 of the embodiment according to Figure 3. The gaps 18 between the sensor chips 10 and the dielectric 2 of the substrate 1 are laterally closed by the mold compound 14.

Figure 6 shows a cross section according to Figure 5 after the formation of apertures 19 in the membrane 15. This embodiment is particularly suitable if both a chemical sensor and a humidity sensor are provided for the semiconductor device. Sensor layers 11 and further sensor layers 11' may be provided for chemical or gas sensors and humidity sensors, respectively. The cavities 17 of the chemical or gas sensors are preferably closed by the membrane 15, which allows the gas that is to be detected to penetrate into the cavity 17, whereas water is prevented from entering the cavity 17. Apertures 19 are formed in the membrane 15 above the humidity sensors to allow moisture to penetrate to the sensors. The apertures 19 may be produced by laser cutting, for instance.

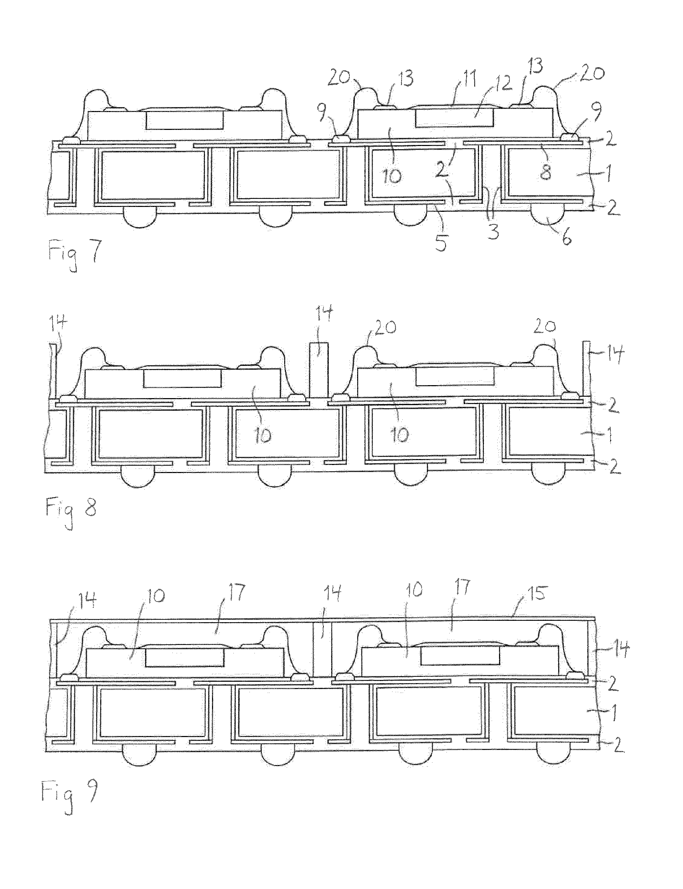

Figure 7 shows a cross section of a further arrangement of sensor chips 10 on a semiconductor substrate 1. The elements of the embodiment according to Figure 7 that are similar to the corresponding elements of the embodiment according to Figure 1 are designated with the same reference numerals. In the embodiment according to Figure 7 the sensor chips 10 are arranged with the contact pads 13 facing away from the substrate 1. The connection between the contact pads 13 of the sensor chips 10 and the contact pads 9 of the substrate 1 is effected by means of bond wires 20.

Figure 8 shows a cross section according to Figure 7 after the application of a mold compound 14 forming compartments around the sensor chips 10 as in the embodiment according to Figure 2.

Figure 9 shows a cross section according to Figure 8 after the application of the sealing membrane 15, which may be polytetrafluoroethylene or expanded polytetrafluoroethylene, for instance. A protection film 16, not shown in Figure 9, may also temporarily be applied as described above.

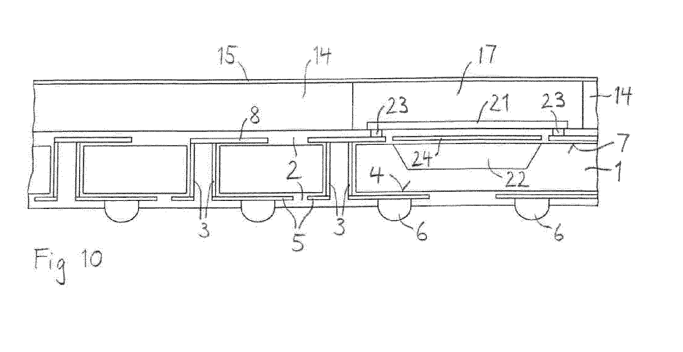

Figure 10 shows a cross section of an embodiment with integrated sensors, which comprise sensor layers 21 that are arranged on or in the substrate 1 without mounting a separate sensor chip. For improved thermal isolation recesses 22 may be formed in the substrate 1 below the sensor layers 21. An electrical connection between the sensor layers 21 and the further wiring layer 8 and/or the through-substrate via 3 may be provided by vertical interconnects or plugs 23 leading through the dielectric 2. If the further wiring layer 8 is arranged contiguous to the sensor layers 21, especially overlapping as shown in Figure 10, and without interspace between the layers in the vertical direction, a direct electric contact between the further wiring layer 8 and the sensor layers 21 may be formed without vertical interconnects or plugs. A hot plate 24 may be integrated in or on the substrate 1 in the vicinity of the sensor layer 21, especially in the case of a gas sensor. The hot plate 24 is preferably a resistive heater, which is heated by an electric current, and may be formed as a conductor track having an appropriate resistance. The cavity 17 is formed above the sensor layer 21 within the mold compound 14 and is closed by the membrane 15, which may be polytetrafluoroethylene or expanded polytetrafluoroethylene, for instance.

When the wafer-level package has been formed by the mold compound and the membrane, the individual semiconductor devices are separated by wafer dicing, cutting through the substrate and through the walls that are formed by the mold compound.

### List of reference numerals

- 1: substrate
- 2: dielectric
- 3: through-substrate via
- 4: front side
- 5: wiring layer
- 6: stud bump
- 7: rear side
- 8: further wiring layer
- 9: contact pad
- 10: sensor chip
- 11: sensor layer
- 11': further sensor layer
- 12: recess
- 13: contact pad
- 14: mold compound
- 15: membrane
- 16: protection film
- 17: cavity
- 18: gap
- 19: aperture
- 20: bond wire
- 21: sensor layer
- 22: recess
- 23: plug
- 24: hot plate
- 25: underfill

## Claims

1. A semiconductor device in wafer-level package, comprising:
- a substrate (1) of semiconductor material with a front side (4) and an opposite rear side (7),
- a wiring layer (5) at the front side (4),
- a further wiring layer (8) at the rear side (7), and
- a through-substrate via (3) connecting the wiring layer (5) and the further wiring layer (8),
**characterized in that**
- a sensor layer (11, 21) is arranged at the rear side (7) above or in the substrate (1) and is electrically connected with the further wiring layer (8), and
- a mold compound (14) is arranged on the rear side (7) and is covered with a membrane (15), the mold compound (14) and the membrane (15) forming a cavity (17) accomodating the sensor layer (11, 21).

2. The semiconductor device according to claim 1, further comprising:
a sensor chip (10) within the cavity (17), the sensor layer (11) being arranged on or in the sensor chip (10).

3. The semiconductor device according to claim 2, wherein the sensor chip (10) is partially embedded into the mold compound (14).

4. The semiconductor device according to claim 1, wherein the sensor layer (21) is arranged on or in the substrate (1).

5. The semiconductor device according to claim 4, further comprising:
an integrated hot plate (24) being arranged on or in the substrate (1) in the vicinity of the sensor layer (21).

6. The semiconductor device according to claim 5, wherein the hot plate (24) is part of the further wiring layer (8).

7. The semiconductor device according to one of claims 1 to 6, wherein
the membrane (15) is polytetrafluoroethylene or expanded polytetrafluoroethylene.

8. The semiconductor device according to one of claims 1 to 7, further comprising:
a further sensor layer (11') arranged at the rear side (7) above or in the substrate (1) and electrically connected with the further wiring layer (8),
the sensor layer (11) being provided for a chemical sensor, and the further sensor layer (11') being provided for a humidity sensor, and
the membrane (15) covering the cavity (17) accomodating the sensor layer (11) and comprising an aperture (19) above the further sensor layer (11').

9. A method of producing a semiconductor device in wafer-level package, comprising:
- forming a plurality of semiconductor devices on a substrate (1) of semiconductor material with a front side (4) and an opposite rear side (7),
- arranging a wiring layer (5) at the front side (4),
- arranging a further wiring layer (8) at the rear side (7), and
- forming through-substrate vias (3) connecting the wiring layer (5) and the further wiring layer (8),
**characterized in that**
- a plurality of sensor layers (11, 21) is arranged in or above the substrate (1) at the rear side (7),
- a mold compound (14) is arranged on the rear side (7) above the substrate (1) and is structured to form a plurality of cavities (17) for the accomodation of the sensor layers (11, 21), and
- the cavities (17) are covered with a membrane (15).

10. The method of claim 9, wherein the membrane (15) is polytetrafluoroethylene or expanded polytetrafluoroethylene.

11. The method of one of claims 9 to 10, wherein the membrane (15) is glued to the mold compound (14).

12. The method of one of claims 9 to 10, wherein the membrane (15) is ultrasonically welded to the mold compound (14).

13. The method of one of claims 9 to 12, wherein the mold compound (14) is applied in a structured fashion by use of a film assisted molding process.

14. The method of one of claims 9 to 13, wherein the sensor layers (11) are applied by mounting a plurality of sensor chips (10) on the rear side (7) of the substrate (1).

15. The method of claim 14, wherein the sensor chips (10) are partially embedded into the mold compound (14).
